Europäisches Patentamt

European Patent Office

Office européen des brevets

(19)

(11) Publication number: **0 146 637 B1**

## EUROPEAN PATENT SPECIFICATION

(12)

(45) Date of publication of patent specification: **19.08.92**   (51) Int. Cl.⁵: **G06F 11/10**, G11B 5/09

(21) Application number: **84902366.8**

(22) Date of filing: **13.06.84**

(86) International application number:
**PCT/JP84/00308**

(87) International publication number:
**WO 85/00065 (03.01.85 85/01)**

(54) **METHOD OF DETECTING ERROR.**

(30) Priority: **17.06.83 JP 108865/83**

(43) Date of publication of application:
**03.07.85 Bulletin 85/27**

(45) Publication of the grant of the patent:
**19.08.92 Bulletin 92/34**

(84) Designated Contracting States:
**AT DE FR GB NL**

(56) References cited:
**GB-A- 2 107 496**
**US-A- 3 697 948**

(73) Proprietor: **SONY CORPORATION**
**7-35 Kitashinagawa 6-chome Shinagawa-ku**
**Tokyo 141(JP)**

(72) Inventor: **TANAKA, Masato Sony Corporation**
**7-35, Kitashinagawa 6-chome**
**Shinagawa-ku Tokyo 141(JP)**
Inventor: **HIMENO, Takuji Sony Corporation**
**7-35, Kitashinagawa 6-chome**
**Shinagawa-ku Tokyo 141(JP)**

(74) Representative: **Ayers, Martyn Lewis Stanley**
**et al**
**J.A. KEMP & CO. 14 South Square Gray's Inn**
**London, WC1R 5EU(GB)**

Rank Xerox (UK) Business Services

**Description**

This invention relates to a method for error detection for use with a so-called digital recording and reproducing apparatus.

In the prior art, it is proposed that an audio signal, for example, is A/D-converted to a digital signal, then recorded and reproduced. In that case, error correction is carried out by so-called cross-interleaving. More particularly, a data word is formed by predetermined number of bits of the digital signal, and a predetermined number of succeeding data words is used to form a data block, in which a CRC check code, for example, produced from a series of words, therein is provided, and parity check code, for example, is provided which has been derived from a series of words from different preceding data blocks in the signal.

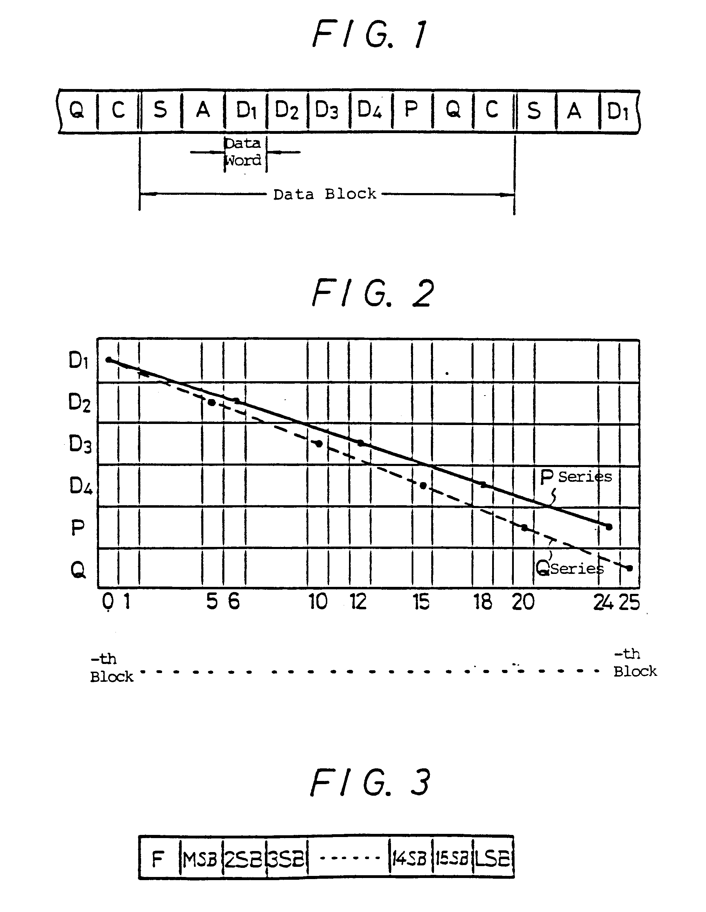

As, for example, shown in Fig. 1 of the accompanying drawings, a data signal to be recorded and reproduced (or transmitted) includes a data block which consists of, sequentially, a synchronizing signal S, an address signal A, data words D1, D2, D3 and D4 of 16 bits each, parity check codes P, Q of 16 bits each and a CRC check code C. This data block is transmitted sequentially. In this case, the CRC check code C is formed for the data words D1 to D4 and the parity check codes P and Q in the same data block. The parity check codes P and Q are formed for series of words from different blocks as, for example, shown by a solid line and a broken line when the data blocks are arranged sequentially as shown in Fig. 2 of the accompanying drawings. In this case, in forming any data block the parity check code Q is formed for the data including a preceding parity check code P, after that check code P has been formed, and then the CRC check code C is formed.

With this arrangement, upon reproducing (or demodulating) the digital signal, for any arbitrary series of data words for an error check code P or Q, when an error which is detected by the CRC check code in a data word contained in that series in only one word, the error can be corrected by the parity check code P or Q. Further, if the error correction in the two series are alternately repeated, the error correction ability can be enhanced.

However, in such apparatus, when a recording medium that was used once is, for example, used again to carry out the recording thereon, the previously recorded data will frequently be reproduced due to the fact that the data is left unerased on the tape. In that case, since the data signal left unerased is correct when seen from only the unerased portion, no error is detected by the CRC check code.

Further, depending on the error content, the detection of the error by the CRC check code will occasionally become impossible in a probability standpoint.

As a result, when such erroneous data signal is unintentionally reproduced, the data signal causes an abnormal sound in the reproduced signal and thereby the tone quality deteriorates considerably.

Further, when in the series of the above parity check code P or Q, both an erroneous data word which is detected by the CRC check code and an erroneous data word which cannot be detected exist simultaneously, the erroneous or mis-correction is carried out for the detected erroneous data word. This erroneous correction affects the succeeding series and hence there is a risk that the erroneous correction will be propagated.

JP-A-57-6419 (Matsushita Denki Sangya K.K.) discloses a digital signal recording system in which errors caused by dropout can be reduced by providing for each frame a cyclic code having a high error converting capability and P and Q diagonal parity check codes for use in increasing the error correcting capability.

GB-A1-2107496 (Hitachi) discloses an error flag processor for digital data in which error flags are set and stored for groups of data as a result of error detection and the reading of the flags and data for correction is controlled by offset counters so as to reduce the flag storage capacity required. P and Q parities are used in the error correction process.

GB-A1-2060227 (Sony) discloses a method of data encoding and decoding similar to that described above with reference to Figures 1 and 2 in which P and Q parity check codes and CRC codes are encoded for data before transmission and are utilized on decoding for detecting and correcting errors.

Philips Technical Review 40,166-172, 1982 No.6 discloses the use of cross-interleaved error correction codes for correcting random and burst errors and the recording of erasure flags to indicate the position of errors, which flags can be used in the error correction process.

According to the present invention there is provided a method of decoding a data signal which comprises data words formed of a predetermined number of bits of digital signals and a plurality of error check codes detecting errors in the data signal comprising the steps of:

forming a data block of a predetermined number of said data words which data words are successive on a recording or transmission medium, said error check codes comprising first error check codes provided for words within a block and a plurality of further error check codes provided for one of a plurality of different series of words each series comprising a plurality of words occupying different positions within respective blocks of a sequence of several data blocks;

providing an error flag for flagging each word as correct or erroneous as a result of a check against one of the error check codes and

correcting erroneous words using said error check codes with reference to the error flags, characterized in that;

firstly all the words in respective blocks are flagged as correct for blocks in which as errors are detected when checked against respective bit error check codes provided for the words within each block;

then data words in a first of said plurality of different series are flagged as erroneous if all of the words in the series initially are flagged as correct and an error is detected as a result of a check against a further error code provided for said series, and this step is repeated for all of the words,

then this step is repeated for the others (Q) of said plurality of series and at each check, errors in each series are corrected where possible in dependency on the number of words flagged by previous checks as erroneous in the series currently being checked.

A second aspect of the invention provides a method of decoding a data signal which comprises data words formed of a predetermined number of bits of digital signals and a plurality of error check codes detecting errors in the data signal comprising the steps of:

forming a data block of a predetermined number of said data words which data words are successive on a recording or transmission medium, said error check codes comprising first error check codes provided for words within a block and a plurality of further error check codes each provided for one of a plurality of different series of words each series comprising a plurality of words occupying different positions within respective blocks of a sequence of several data blocks;

providing an error flag for flagging each word as correct or erroneous as a result of a check against one of the error check codes, and

correcting erroneous words using said error check codes with reference to the error flags characterized in that;

first and second error flats are provided for each word, and in that:

(a) firstly, all the flags of words in respective blocks in which an error is detected as a result of a check against said first error check code are placed in a first state otherwise the flags being in a second state then

(b) the first flags of words in one of said plurality of different series are placed in a third state if error is detected as a result of a check against the respective further error check code or are placed in a fourth state if the result of the check is correct and this step is repeated for all the words; then

(c) the second flag of words in another of said plurality of different series are placed in said third state if an error is detected as a result of a check against the respective further error check code, or are placed in a fourth state if the result of the check is correct and this step is repeated for all the words;

(d) subsequently error correction is carried out in dependency on the flag set.

The invention will be further described by way of non-limitative example with reference to the accompanying drawings, in which:

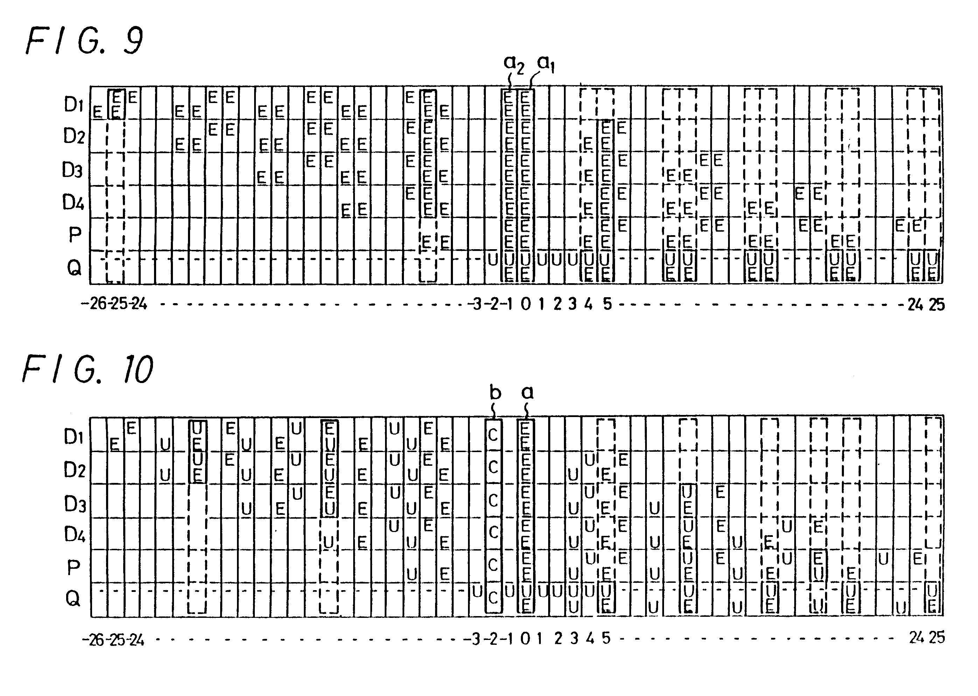

Figs. 1 and 2 are diagrams useful for explaining prior art error detection and error correction and Figs. 3 to 10 are diagrams useful for explaining this invention.

In Fig. 3, an area for a flag F (one bit) used as an error pointer together with a data area of 16 bits are provided in each word area of a random access memory, in which data words are written. In this case, the overall arrangement of the random access memory, is such as shown in Fig. 2, and word areas extending in the right-hand and left- hand side directions thereof are added with the addresses of the number corresponding to the data block that concerns one error correction.

Firstly, all the flags F are set to "1" for such random access memory.

Then, the data signals D1 to D4, and the parity check codes P and Q of the data block that is judged as having no error by the CRC check code C are written in the random access memory at the addresses corresponding to the address signal A and the flag F of each written word is changed to "0".

Further, a check is carried out in the series of the parity check code P. At this time, if it is judged that there is no data word with the flag "1" and the data word is judged erroneous by the parity check, the flags F of all the data words contained in this series are set to "1". This will be carried out on all the data blocks.

Furthermore, another check is carried out in the series of the parity check code Q. When it is judged that there is no data word with the flag F "1" and the data word is judged erroneous by the parity check, the flags F of all the data words that are contained in such series are set to "1". If, for the other cases than mentioned above, there is only one data word with the flag F "1", the error correction is carried out. This will be carried out for all the data blocks.

3

Similarly to the prior art, the error corrections in the series of the parity check codes P and Q are hereinafter alternately carried out so as to enhance the error correction ability.

As described above, the error detection and the error correction are carried out. According to this method, it is possible to prevent the error from being caused by overlooking the above CRC check code. Moreover, there is no risk that the influence of the erroneous correction is spread.

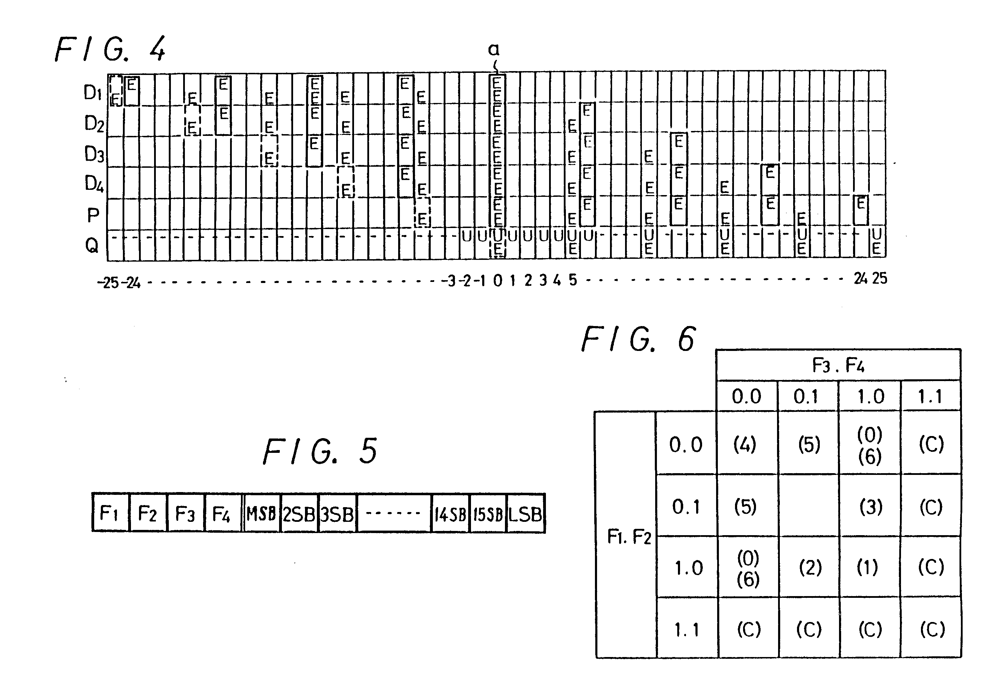

That is, when, in Fig. 4, only the central data block a is erroneous because of the data left unerased on the tape and this error is not detected by the CRC check code C, if the check is carried out in the series of the parity check code P, the data words encircled by the solid lines are regarded as being erroneous and the flags F thereof are set to "1". Then, the check is carried out in the series of the parity check code Q. At this time, since the flags of the data words D1 to D4 and the parity check code P within the data block a were already set to "1" following the P series checks, the series including this data word is not parity checked but data words forming the series of check code Q and encircled by broken lines are regarded as being erroneous and the flags F thereof are set to "1". Thereafter, error correction is carried out by using these flags. In the figure, reference letters E designate data words which are contained in the data blocks having errors, while data words E that are not encircled by the lines are words judged as being erroneous when the check by the series of the parity check code Q is previously made.

However, in the above method, when the series is judged as being erroneous by the parity check, although only one data word is erroneous in the series, all the data words in that series are judged as being erroneous so that correct data words are also judged as being erroneous and thus the number of data words judged erroneous is increased considerably. In this case, since the series of the parity check code P is frequently particularly identical with the input/output series of AD/DA before being cross-interleaved, this series directly affects the tone quality. Thus, if in this series there exist many erroneous data words, the tone quality is extremely deteriorated.

When all the data words in the series of the parity check code P or Q are regarded as being erroneous, it becomes very difficult to completely correct the erroneous data words by using the other series. And, there is a risk that as a result interpolation or the like will be employed and hence the tone quality will be deteriorated.

Therefore, as shown in Fig. 5, together with the data area of 16 bits, area of flags F1, F2, F3 and F4 of 4 bits for an error pointer are provided in each word area of the random access memory. The flags F1 and F2 are used for the series of the parity check code P and the flags F3 and F4 are used for the series of the parity check code Q. The flags are set to (0,0) for data which is judged as being free from error by the respective parity checks, to (0,1) for data whose parity check is impossible, since the CRC check has shown there to be one or more erroneous data words, to (1,0) for data which is judged as being erroneous by the parity check and to (1,1) for data which is judged as being erroneous by the CRC check code.

In accordance with this arrangement, all the data blocks are judged by the series of the parity check codes P and Q in the following manner.

Firstly, the flags F1 to F4 in the random access memory are all set to "1". This will mean that if, after new data is entered, any old data remains in the memory, its check flag will show an error.

Then, the data signals D1 to D4 and the parity check codes P and Q of the data blocks which are judged as having no error by the CRC check code C are written in random access memory at the addresses corresponding to the address signal A and the flags F1 to F4 of each written word are set to (0,1,0,1).

Then, the check is carried out in the series of the parity check code P. When this series has no data word that is judged as being erroneous by the CRC check code C and no error is detected by the parity check, the flags F1 and F2 of all the data words in that series are set to (0,0). When a parity error is detected, the flags F1 and F2 are set to (1,0). When there are one or more data words flagged as being erroneous by the CRC check code C (e.g. because the series includes memory locations containing old not written over) the flags are left unchanged. This process is carried out on all the data blocks.

Then the check using the series of the parity check code Q, is carried out and the flags F3 and F4 are rewritten as required in similar manner. This process is carried out on all the data blocks.

As a result, data words having the flags F1 to F4 expressed by the following equations

$$(F1, F2, F3, F4) = (1, 0, 1, 0) \quad \ldots (1)$$
$$= (1, 0, 0, 1) \quad \ldots (2)$$
$$= (0, 1, 1, 0) \quad \ldots (3)$$

have an extremely large possibility of being erroneous because they are judged as being erroneous by both P and Q series, or have some possiblility of being erroneous because they are judged as being erroneous by one series and cannot be checked for error by the other series. These data words are therefore regarded as being erroneous.

Other data words which have either been judged as being erroneous by one series and free from error by the other seres, or free from error by both series are then regarded as data words having no error.

More specifically, in Fig. 6, the portion (C) which is judged as being erroneous by the CRC check code C and the portions (1), (2) and (3) which are judged as being erroneous according to the above equations (1), (2) and (3) are regarded as erroneous. But while in the previous example, even the portion (0) was regarded as being erroneous, in this case, this portion is not regarded as erroneous and hence the number of erroneous words is reduced.

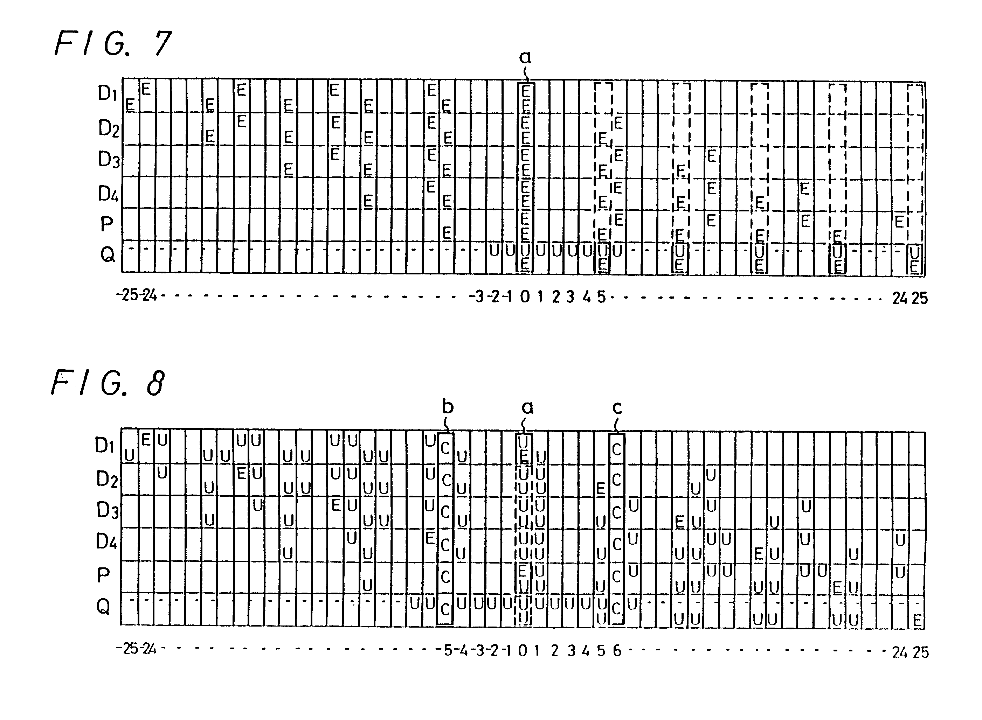

Thus, in Fig. 7, under the same condition as that of Fig. 4, only the erroneous data block a encircled by the solid line and the portion Q that is not judged by the series of the parity check code P are regarded as being erroneous.

Accordingly, the number of the correct data words which are regarded as being erroneous can be reduced. Thus, the possibility that the tone quality is deteriorated is reduced.

Further, in Fig. 8, when there are data blocks b and c which will be judged as being erroneous by the CRC check code C together with the erroneous data a, the states of the flags F1 to F4 of each data word become as shown in the figure. The result checked by the series of the parity check code P is indicated on the upper side of each box by a letter and the result checked by the sequence of the parity check code Q is indicated on the lower side of each box by a letter. Of the reference letters E designates (1,0), U designates (0,1), C designates (1,1,1,1) and a block designates (0,0). In this case, the data words which are regarded as being erroneous are only the data words contained in the data blocks b and c encircled by the solid lines and detected by the CRC check code C and the data words D1 and P of the data block a.

Fig. 9 shows a case in which there is no error detected by the CRC check code C and two data blocks $a_1$ and $a_2$ are successively erroneous. In this case, the data words which are regarded as being erroneous are encircled by the solid lines.

Fig. 10 shows a case in which there is an erroneous data block b detected by the CRC check code C in the vicinity of the erroneous data block a. In this case, the data words which are regarded as being erroneous are encircled by the solid line.

It will be seen that, in accordance with the above method, only data words which show errors in both P and Q checks or an error in one and are uncheckable by the other are finally regarded as erroneous.

However, in this method, if in each of the series of the parity check codes P and Q there are one or more data words judged erroneous by the CRC check code C, the detection of the data words becomes impossible. That is, the detection of the data words D1 to D4 and Q within the data block a in Fig. 8 becomes impossible and hence there is a risk that the error will be overlooked.

Further, as described previously, in the case of the cross-interleaving of non-recursive type in which the series of the parity check code P does not include check word Q, if there is only one erroneous data word detected by the CRC check code C in a series of Q including an erroneous parity check code Q, the detection of the error becomes impossible and a mis-correction is carried out because of the overlooked erroneous data word. As a result, there is a risk that the erroneous correction will be propagated.

However, in a data block which is not detected by the CRC code C, but which is erroneous it is very likely that all the words in the data block are erroneous. This property is used to increase the accuracy of the process in the following manner.

After the above detection, the data words of a data block including even one erroneous data word are regarded as being erroneous and the flags F1 to F4 are set to (1,1,1,1,). That is, the data words encircled by the broken lines in Figs. 7 to 10 are all regarded as being erroneous.

Thus, it is possible to reduce the possibility of overlooking the erroneous data words.

However, in this case, if there are many data blocks which are judged as being erroneous by the CRC check code C, there is a fear that correct data words are judged as being erroneous by the parity check and the data word is regarded as being erroneous unnecessarily. Further, if an erroneous data block which is not detected by the CRC check code C exists near a correct data word, the correct data word is judged as being erroneous by both series of the parity check codes P and Q so that the whole of the data block in which the data word is contained is regarded as being erroneous.

Accordingly, in the above detection, the data words that are judged as being correct, namely, the portions (4), (5) and (6) in Fig. 6 are detected and only when no correct data word is unchanged in the data block, all the data words contained in that data block are judged as being erroneous.

For example, if there is even one correct data word which remains unchanged after checking, all the data words in that data block are regarded as being correct. Thus, as shown in Figs. 7 to 10, the data blocks other than the data blocks a, b, c, $a_1$ and $a_2$ contain the correct data words, and if these data blocks are regarded as being correct, it is possible to specify the erroneous data blocks substantially perfectly.

There may be a case where a partial data word in an erroneous data block will occasionally be judged as being correct and so a similar, but more advanced procedure may be used in which the number of the correct data words in that data block is detected. Then, if the detected number is beyond a predetermined number, the data block is judged as being correct. Further, it is also possible to weight favourably data words judged as correct by all three checks, i.e. with flags (0,0,0,0), in the counting of the number of the correct data words.

In the above examples the data words which are regarded as being erroneous have their flags F1 to F4 thereof rewritten as (1,1,1,1) and these erroneous data words are processed similarly to those that are judged as being erroneous by the CRC check code C.

**Claims**

1. A method of decoding a data signal which comprises data words ($D_{1-4}$,) formed of a predetermined number of bits of digital signals and a plurality of error check codes (P, Q, C), detecting errors in the data signal comprising the steps of:

   forming a data block of a predetermined number of said data words ($D_{1-4}$) which data words are successive on a recording or transmission medium, said error check codes comprising first error check codes (C) provided for words within a block, and a plurality of further error check codes (P, Q) each provided for one of a plurality of different series of words each series comprising a plurality of words occupying different positions within respective blocks of a sequence of several data blocks;

   providing an error flag for flagging each word as correct or erroneous as a result of a check against one of the error check codes (C, P, Q), and

   correcting erroneous words using said error check codes (C, P, Q) with reference to the error flags,

   characterized in that;

   firstly all the words in respective blocks are flagged as correct for blocks in which no errors are detected when checked against respective first error check codes (C) provided for the words within each block;

   then data words in a first (P) of said plurality of different series are flagged as erroneous if all of the words in the series initially are flagged as correct and an error is detected as a result of a check against a further error code (P) provided for said series, and this step is repeated for all of the words,

   then this step is repeated for the others (Q) of said plurality of series and at each check, errors in each series are corrected where possible in dependency on the number of words flagged by previous checks as erroneous in the series currently being checked.

2. A method of decoding a data signal which comprises data words ($D_{1-4}$) formed of a predetermined number of bits of digital signals and a plurality of error check codes (C, P, Q), detecting errors in the data signal comprising the steps of:

   forming a data block of a predetermined number of said data words ($D_{1-4}$) which data words are successive on a recording or transmission medium, said error check codes (C, P, Q) comprising first error check codes (C) provided for words within a block and a plurality of further error check codes (P, Q) each provided for one of a plurality of different series of words each comprising a plurality of words occupying different positions within respective blocks of a sequence of several data blocks;

   providing an error flag ($F_1$, $F_2$, $F_3$, $F_4$) for flagging each word as correct or erroneous as a result of a check against one of the error check codes, and

   correcting erroneous words using said error check codes with reference to the error flags ($F_1$, $F_2$, $F_3$, $F_4$),

   characterized in that:

first ($F_1$, $F_2$) and second ($F_3$, $F_4$) error flags are provided for each word, and in that:

(a) firstly, all the flags ($F_1$, $F_2$, $F_3$, $F_4$) of words in respective blocks in which no error is detected as a result of a check against said first error check code (C) are placed in a first state (0,1) otherwise the flags ($F_1$, $F_2$, $F_3$, $F_4$) being in a second state (1,1); then

(b) the first flags ($F_1$, $F_2$) of words in one of said plurality of different series are placed in a third state (1,0) if error is detected as a result of a check against the respective further error check code (P) or are placed in a fourth state (0,0) if the result of the check is correct and this step is repeated for all the words; then

(c) the second flag ($F_3$, $F_4$) of words in another of said plurality of different series (Q) are placed in said third state (1,0) if an error is detected as a result of a check against the respective further error check code, or are placed in a fourth state (0,0) if the result of the check is correct and this step is repeated for all the words;

(d) subsequently error correction is carried out in dependency on the flag ($F_1$, $F_2$, $F_3$, $F_4$) set.

3. A method according to claim 2 in which after step (c) both the first and second flags ($F_1$ $F_2$; $F_3$ $F_4$) are set to the second state (1, 1, 1, 1) for words in which one of the flags ($F_1$ $F_2$; $F_3$ $F_4$) is already in the second state (1,1) and for any other words in which neither flag ($F_1$ $F_2$; $F_3$ $F_4$) is in the fourth state (0,0), and the error correction of step (d) is subsequently carried out.

4. A method according to claim 3 in which after step (c) and before said subsequent error correction step (d) both the first ($F_1$, $F_2$) and second flags ($F_3$, $F_4$) are set in the second state (1,1) for all the words in blocks in which any word already has both its first ($F_1$, $F_2$) and second ($F_3$, $F_4$) flags set to the second state (1,1).

5. A method according to claim 3 in which after step (c) and before said subsequent error correction step (d) both the first ($F_1$, $F_2$) and second ($F_3$, $F_4$), flags are set to the fourth state (0,0) for all the words in blocks which contain one or more words having at least one flag ($F_1$, $F_2$) in the fourth state (0,0) and neither flag ($F_1$, $F_2$) in the second state (1,1) otherwise both the first ($F_1$, $F_2$) and second ($F_3$, $F_4$) flags for all the words in the block being set to the second state (1,1).

6. A method according to any one of claims 1 to 5 in which no check is made against the further error check codes (P, Q) for series containing more than one word flagged as erroneous as a result of the check against the first error check code (C), the flags of words in the series being left unchanged.

7. A method according to any one of the preceding claims wherein the first check code is a CRC check code and the further check codes are P and Q parity check codes.

**Patentansprüche**

1. Verfahren zum Dekodieren eines Datensignals, welches Datenwörter (D1-4) umfaßt, die aus einer vorbestimmten Anzahl von Bits digitaler Signale und einer Vielzahl von Fehlerprüfcodes (P, Q, C) gebildet sind, wobei das Verfahren zur Ermittlung der Fehler im Datensignal die Schritte umfaßt:

Bildung eines Datenblockes aus einer vorbestimmten Anzahl von Datenwörtern (D1-4), wobei die Datenwörter nacheinander auf einem Aufzeichnungs- und Übertragungsmedium angeordnet sind, wobei die Fehlerprüfcodes einen ersten Fehlerprüfcode (C) umfassen, der für Wörter innerhalb eines Blockes vorgesehen ist, sowie eine Vielzahl von weiteren Fehlerprüfcodes, die jeweils für eine von einer Vielzahl von verschiedenen Serien von Wörtern vorgesehen sind, wobei eine Serie eine Vielzahl von Wörtern umfaßt, die verschiedene Positionen innerhalb entsprechender Blöcke einer Folge mehrerer Datenblök-ke besetzt;

Vorsehen eines Fehlerkennzeichens zur Kennzeichnung jeden Wortes als korrekt oder fehlerhaft als Ergebnis einer Prüfung gegenüber einen der Fehlerprüfcodes (C, P,Q), und

Korrektur fehlerhafter Wörter, die die Fehlerprüfcodes (C, P, Q) in Bezug auf die Fehlerkennzeichen verwenden,

dadurch gekennzeichnet:

zuerst werden alle Wörter in den entsprechenden Blöcken als korrekt für die Blöcke gekennzeichnet, in welchen keine Fehler erkannt werden, wenn sie gegenüber den entsprechenden Fehlerprüfcodes (C) geprüft werden, die für die Wörter eines jeden Blockes vorgesehen sind;

dann werden die Datenwörter in einer ersten von einer Vielzahl von verschiedenen Serien als fehlerhaft gekennzeichnet, wenn alle Wörter in den Serien anfänglich als korrekt gekennzeichnet werden und ein Fehler als Ergebnis einer Prüfung gegenüber einem weiteren Fehlercode ermittelt wird, der für diese Serien vorgesehen ist, und dieser Schritt wird für alle Wörter wiederholt,

dann wird dieser Schritt für die andere Vielzahl(Q) von Serien wiederholt und bei jeder Prüfung werden die Fehler in jeder Serie wo möglich korrigiert in Abhängigkeit von der Anzahl der Wörter, die durch frühere Prüfungen als fehlerhaft in den Serien gekennzeichnet wurden, die laufend geprüft wurden.

**2.** Verfahren zum Dekodieren eines Datensignals, welches Datenwörter (D1-4) umfaßt, die aus einer vorbestimmten Anzahl von Bits digitaler Signale und einer Vielzahl von Fehlerprüfcodes (C, P, Q) gebildet sind, wobei die Ermittlung der Fehler im Datensignal die Schritte umfaßt:

Bildung eines Datenblockes einer vorbestimmten Anzahl von Datenwörtern (D1-4), wobei die Datenwörter nacheinander auf einem Aufzeichnungs- oder Übertragungsmedium angeordnet sind, wobei die Fehlerprüfcodes (C, P, Q) erste Fehlerprüfcodes umfassen, die für Wörter innerhalb eines Blockes vorgesehen sind, und eine Vielzahl von weiteren Fehlerprüfcodes, die jeweils für eine von einer Vielzahl von verschiedenen Serien von Wörtern vorgesehen ist, wobei jede Serie eine Vielzahl von Wörtern umfaßt, die verschiedene Positionen innerhalb entsprechender Blöcke einer Folge von mehreren Datenblöcken besetzen;

Vorsehen eines Fehlerkennzeichens (F1, F2, F3, F4) zur Kennzeichnung jeden Wortes als korrekt oder fehlerhaft als Ergebnis einer Prüfung gegenüber den Fehlerprüfcodes, und

Korrektur von fehlerhaften Wörtern, die diese Fehlerprüfcodes in Bezug auf die Fehlerkennzeichen (F1, F2, F3, F4) verwenden,

gekennzeichnet durch folgende Schritte:

erste (F1, F2) und zweite (F3, F4) Fehlerkennzeichen werden für jedes Wort vorgesehen,

(a) zuerst werden alle Kennzeichen (F1, F2, F3, F4) von Wörtern in entsprechenden Blöcken, in welchen kein Fehler als Ergebnis einer Prüfung gegenüber dem ersten Fehlerprüfcode (C) erkannt wird, in einer ersten Lage (0,1) angeordnet, die verschieden ist gegenüber den Kennzeichen (F1, F2, F3, F4), die in einer zweiten Lage (1,1) angeordnet sind;

(b) die ersten Kennzeichen (F1, F2) der Wörter von einer Vielzahl von verschiedenen Serien werden in einer dritten Lage (1,0) angeordnet, wenn ein Fehler als Ergebnis einer Prüfung gegenüber dem entsprechenden weiteren Fehler-Prüfcode (P) ermittelt wird, oder sie werden in einer vierten Lage (0,0) angeordnet, wenn das Ergebnis der Prüfung "korrekt" ergibt und dieser Schritt für alle Wörter wiederholt wird;

(c) die zweiten Kennzeichen (F3, F4) von Wörtern in einer anderen von einer Vielzahl verschiedener Serien werden in der dritten Lage (1,0) angeordnet, wenn ein Fehler erkannt wird als Ergebnis einer Prüfung gegenüber dem entsprechenden weiteren Fehler- Prüfcode, oder sie werden in einer vierten Lage (0,0) angeordnet, wenn das Ergebnis der Prüfung "korrekt" ergibt und dieser Schritt für alle Wörter wiederholt wird;

(d) die nachfolgende Fehlerkorrektur wird in Abhängigkeit des Kennzeichen-Sets (F1, F2, F3, F4) ausgeführt.

**3.** Verfahren nach Anspruch 2, bei welchem nach Schritt (c) erste und zweite Kennzeichen (F1, F2, F3, F4) in die zweite Lage (1, 1, 1, 1) für Wörter gesetzt werden, in welcher eines der Kennzeichen (F1 F2; F3 F4) sich schon in der zweiten Lage (1,1) befindet und für alle anderen Wörter, bei welchen keine von beiden Kennzeichen (F1 F2;F3 F4) sich in der vierten Lage (0,0) befinden, wird die Fehlerkorrektur des Schrittes (d) später ausgeführt.

**4.** Verfahren nach Anspruch 3, bei welchem nach Schritt (c) und vor dem folgenden Fehler-Korrekturschritt (d) sowohl die ersten (F1, F2) als auch die zweiten Kennzeichen (F3, F4) in die zweite Lage (1,1) für alle die Wörter in Blöcken gesetzt werden, in welchen jedes Wort schon sowohl sein erstes (F1,F2) als auch sein zweites Kennzeichen (F3,F4) hat, das in die zweite Lage (1,1) gesetzt wurde.

**5.** Verfahren nach Anspruch 3, bei welchem nach Schritt (c) und vor folgendem Fehler-Korrekturschritt (d) sowohl die ersten (F1, F2) und zweiten (F3, F4) Kennzeichen in die vierte Lage (0,0) für alle Wörter in Blöcken gesetzt werden, die ein oder mehrere Wörter enthalten, die wenigstens ein Kennzeichen (F1, F2) in der vierten Lage (0,0) und keine Kennzeichen (F1,F2) in der zweiten Lage (1,1) haben, wobei anderenfalls sowohl erste (F1, F2) und zweite (F3, F4) Kennzeichen für alle Wörter eines Blockes in die zweite Lage (1,1) gesetzt werden.

**6.** Verfahren nach einem der Ansprüche 1 bis 5, bei welchem keine Prüfung durchgeführt wird gegenüber den weiteren Fehlerprüfcodes (P,Q) für Serien, die mehr als ein Wort als fehlerhaft gekennzeichnet enthalten als ein Ergebnis einer Prüfung gegenüber dem ersten Fehlerprüfcode (C), wobei die Kennzeichen der Wörter in den Serien als unverändert belassen werden.

**7.** Verfahren nach einem der vorhergehenden Ansprüche, wobei der erste Prüfcode ein CRC- Prüfcode ist und die weiteren Prüfcodes P- und Q- Parity- Prüfcodes sind.

**Revendications**

**1.** Procédé de décodage d'un signal de données qui contient des mots de données ($D_{1-4}$) formés d'un nombre prédéterminé de bits de signaux numériques et de plusieurs codes de vérification d'erreur (P, Q, C) de détection d'erreurs du signal de données, comprenant les étapes suivantes :

la formation d'un bloc de données comprenant un nombre prédéterminé de mots de données ($D_{1-4}$), ces mots de données se suivant sur un support d'enregistrement ou de transmission, les codes de vérification d'erreur comprenant des premiers codes de vérification d'erreur (C) destinés aux mots d'un bloc, et plusieurs codes supplémentaires de vérification d'erreur (P, Q) destinés chacun à l'une de plusieurs séries différentes de mots, chaque série comprenant plusieurs mots occupant des positions différentes dans des blocs respectifs d'une séquence de plusieurs blocs de mots,

la disposition d'un drapeau d'erreur destiné à signaler chaque mot comme étant convenable ou erroné à la suite d'une vérification d'après les codes de vérification d'erreur (C, P, Q), et

la correction des mots erronés à l'aide des codes de vérification d'erreur (C, P, Q) en référence aux drapeaux d'erreur,

caractérisé en ce que

d'abord, tous les mots des blocs respectifs sont signalés comme convenables dans les blocs dans lesquels aucune erreur n'est détectée lors de la vérification avec les premiers codes respectifs de vérification d'erreur (C) donnés pour les mots de chaque bloc,

puis les mots de données d'une première (P) de plusieurs séries différentes sont signalés comme erronés lorsque tous les mots de la série sont signalés initialement comme convenables et une erreur est détectée à la suite d'une vérification d'après un code supplémentaire de vérification d'erreur (P) associé à la série, et

cette étape est répétée pour tous les mots, puis cette étape est répétée pour le autres séries (Q) des différentes séries et, à chaque vérification, les erreurs de chaque série sont corrigées lorsque cela est possible, en fonction du nombre de mots marqués comme erronés dans la série actuellement vérifiée, par les vérifications antérieures.

**2.** Procédé de décodage d'un signal de données qui contient des mots de données ($D_{1-4}$) formés d'un nombre prédéterminé de bits de signaux numériques et de plusieurs codes de vérification d'erreur (C, P, Q) de détection des erreurs dans le signal de données, comprenant les étapes suivantes :

la formation d'un bloc de données d'un nombre prédéterminé de mots de données ($D_{1-4}$), ces mots de données se suivant sur un support d'enregistrement ou de transmission, les codes de vérification d'erreur (C, P, Q) comprenant un premier code de vérification d'erreur (C) associé aux mots d'un bloc et plusieurs codes supplémentaires de vérification d'erreur (P, Q) associés chacun à l'une de plusieurs séries différentes de mots contenant chacune plusieurs mots occupant des positions différentes dans les blocs respectifs d'une séquence de plusieurs blocs de données,

la disposition d'un drapeau d'erreur ($F_1$, $F_2$, $F_3$, $F_4$) pour la signalisation de chaque mot comme étant convenable ou erroné à la suite de la vérification d'après l'un des codes de vérification d'erreur, et

la correction des mots erronés à l'aide des codes de vérification d'erreur en référence aux drapeaux d'erreur ($F_1$, $F_2$, $F_3$, $F_4$),

caractérisé en ce que,

des premiers ($F_1$, $F_2$) et des seconds ($F_3$, $F_4$) drapeaux d'erreur sont associés à chaque mot, et en ce que

(a) d'abord, tous les drapeaux ($F_1$, $F_2$, $F_3$, $F_4$) des mots des blocs respectifs dans lesquels aucune erreur n'est détectée à la suite d'une vérification d'après le premier code de vérification d'erreur (C), sont placés dans un premier état (0,1), et dans le cas contraire, les drapeaux ($F_1$, $F_2$, $F_3$, $F_4$) sont à un second état (1,1), puis

(b) les premiers drapeaux ($F_1$, $F_2$) des mots de l'une des différentes séries sont placés dans un troisième état (1,0) lorsqu'une erreur est détectée à la suite d'une vérification avec le code supplémentaire respectif (P) de vérification d'erreur ou sont placés à un quatrième état (0,0) lorsque le résultat de la vérification est convenable, et cette étape est répétée pour tous les mots, puis

(c) les seconds drapeaux ($F_3$, $F_4$) des mots d'une autre série des différentes séries (Q) sont placés au troisième état (1,0) si une erreur est détectée à la suite d'une vérification avec le code supplémentaire respectif de vérification d'erreur, ou sont placés à un quatrième état (0,0) lorsque le résultat de la vérification est convenable, et cette étape est répétée pour tous les mots,

(d) ensuite, la correction d'erreur est exécutée en fonction de l'état des drapeaux ($F_1$, $F_2$, $F_3$, $F_4$).

3. Procédé selon la revendication 2, dans lequel, après l'étape (c), les premiers et seconds drapeaux ($F_1$, $F_2$ ; $F_3$, $F_4$) sont mis au second état (1,1,1,1) pour les mots dans lesquels l'un des drapeaux ($F_1$, $F_2$ ; $F_3$, $F_4$) est déjà au second état (1,1) et pour tous les autres mots dans lesquels aucun drapeau ($F_1$, $F_2$ ; $F_3$, $F_4$) n'est au quatrième état (0,0), et la correction d'erreur de l'étape (d) est exécutée ensuite.

4. Procédé selon la revendication 3, dans lequel, après l'étape (c) et avant l'étape suivante de correction d'erreur (d), les premiers drapeaux ($F_1$, $F_2$) et les seconds drapeaux ($F_3$, $F_4$) sont mis au second état (1,1) pour tous les mots des blocs dans lesquels un mot quelconque a déjà à la fois ses premiers drapeaux ($F_1$, $F_2$) et seconds drapeaux ($F_3$, $F_4$) mis au second état (1,1).

5. Procédé selon la revendication 3, dans lequel, après l'étape (c) et avant l'étape suivante de correction d'erreur (d), les premiers drapeaux ($F_1$, $F_2$) et les seconds drapeaux ($F_3$, $F_4$) sont mis au quatrième état (0,0) pour tous les mots des blocs qui contiennent un ou plusieurs mots ayant au moins un drapeau ($F_1$, $F_2$) au quatrième état (0,0) et aucun drapeau ($F_1$, $F_2$) au second état (1,1), et dans le cas contraire, les premiers drapeaux ($F_1$, $F_2$) et les seconds drapeaux ($F_3$, $F_4$) de tous les mots du bloc sont mis au second état (1,1).

6. Procédé selon l'une quelconque des revendications 1 à 5, dans lequel aucune vérification n'est réalisée avec les codes supplémentaires de vérification d'erreur (P, Q) pour les séries contenant plus d'un mot signalé erroné à la suite de la vérification réalisée avec le premier code de vérification d'erreur (C), les drapeaux des mots de la série restant inchangés.

7. Procédé selon l'une quelconque des revendications précédentes, dans lequel le premier code de vérification est un code de vérification CRC, et les codes supplémentaires de vérification sont des codes de vérification de parité P et Q.

## F I G. 1

## F I G. 2

## F I G. 3

FIG. 4

FIG. 6

| F1.F2 | F3.F4 | | | |
|---|---|---|---|---|
| | 0.0 | 0.1 | 1.0 | 1.1 |
| 0.0 | (4) | (5) | (0)(6) | (C) |
| 0.1 | (5) | | (3) | (C) |
| 1.0 | (0)(6) | (2) | (1) | (C) |
| 1.1 | (C) | (C) | (C) | (C) |

FIG. 5

| F1 | F2 | F3 | F4 | MSB | 2SB | 3SB | ------- | 14SB | 15SB | LSB |

# FIG. 7

EP 0 146 637 B1

a

| | D1 |
| | D2 |
| | D3 |
| | D4 |
| | P |
| | Q |

-25 -24 · · · · · · · · · · · · · · · -3 -2 -1 0 1 2 3 4 5 · · · · · · · · · · · · · 24 25

# FIG. 8

b    a    c

| | D1 |
| | D2 |
| | D3 |
| | D4 |
| | P |
| | Q |

-25 -24 · · · · · · · · · · · · -5 -4 -3 -2 -1 0 1 2 3 4 5 6 · · · · · · · · · · · · 24 25

# FIG. 9

$a_2$ $a_1$

D1 D2 D3 D4 P Q

-26 -25 -24 - - - - - - - - - - - - -3 -2 -1 0 1 2 3 4 5 - - - - - - - 24 25

# FIG. 10

b a

D1 D2 D3 D4 P Q

-26 -25 -24 - - - - - - - - - - - - - -3 -2 -1 0 1 2 3 4 5 - - - - - - - - 24 25

EP 0 146 637 B1